# EUROPÄISCHE PATENTSCHRIFT

(11) **EP 0 917 732 B1**
(45) Veröffentlichungstag und Bekanntmachung des Hinweises auf die Patenterteilung: **31.10.2001**
(21) Anmeldenummer: 97937436.0
(22) Anmeldetag: 07.08.1997
(51) Int. Cl.: H01L 21/68

(54) **WAFERRAHMEN**
WAFER FRAME
CADRE POUR TRANCHES

(30) Priorität: 08.08.1996 DE 19632094
(43) Veröffentlichungstag der Anmeldung: 26.05.1999
(73) Patentinhaber: Infineon Technologies AG, 81669 München (DE)
(72) Erfinder: LÖSCH, Harald, Horst, Josef, deceased (DE); MERKL, Reinhold, Richmond, VA 23219 (US); HOUDEAU, Detlef, D-84085 Langquaid (DE)
(74) Vertreter: Zedlitz, Peter, Dipl.-Inf.
(86) Internationale Anmeldenummer: DE9701676
(87) Internationale Veröffentlichungsnummer: WO9807188

(56) Entgegenhaltungen:
- EP-A- 0 363 480
- EP-A- 0 571 649
- EP-A- 0 671 763
- DATABASE WPI Section Ch, Week 8738 Derwent Publications Ltd., London, GB; Class A35, AN 87-268074 XP002048064 & JP 62 187 035 A (HITACHI CHEM CO LTD) , 15.August 1987
- PATENT ABSTRACTS OF JAPAN vol. 015, no. 233 (E-1077), 14.Juni 1991 & JP 03 069128 A (TORAY IND INC), 25.März 1991,

## Beschreibung

Die Erfindung betrifft einen Waferrahmen zur Aufnahme von scheibenförmigen dünnen Halbleiterwafern, die in der Regel rund ausgebildet sind. Derartige mit Wafern bestückte Waferrahmen werden beispielsweise in einer Kassette übereinander in Horden transportiert und entsprechenden Bearbeitungsstationen zugeführt.

Zur Herstellung von Halbleiterchips werden auf Halbleiterwafern beispielsweise photolithographhische und ätztechnische Strukturierungen vorgenommen. Auf einem Wafer ist dabei eine Vielzahl von Halbleiterchips vorhanden. Bei der Strukturierung auf dem Wafer werden die aktiven Bereiche auf dem Wafer, die später den Einzelchip darstellen, durch ein vorbestimmtes Raster beabstandet, so daß Zonen oder Linien entstehen, entlang der der Wafer getrennt werden kann. Ein hierzu gängiges Verfahren ist das sog. Trennschleifen mit einer hochtourigen Diamantscheibe. Zu diesem Verfahren wird der Wafer mit einer Vakuumvorrichtung positionsgenau gehalten bzw. geführt. Dazu wird ein Waferrahmen zunächst oberseitig mit einer Folie belegt, auf der der Wafer obenauf mit seiner nicht strukturierten Seite nach unten aufgebracht wird. Somit wird verhindert, daß die nach der Vereinzelung vorliegenden einzelnen Chips mechanisch beschädigt werden. Die Vakuumvorrichtung wird zentral zum Waferrahmen mit seinem zentralen Durchgang von unten her auf der Folie aufgesetzt, wobei der Wafer bzw. Wafer und Folie angesaugt und arretiert werden. Die Schnittiefe beim Trennschleifen ist derart ausgelegt, daß der Wafer annähernd oder ganz durchgeschnitten wird und die Schnittiefe geringfügig in die Folie hineinreicht.

Zur Optimierung der gesamten Herstellungsprozesse sind die Durchmesser der Wafer ständig erhöht worden. Lagen sie früher bei 4, 5 oder 6 Zoll, so werden heute Wafer mit 8 Zoll eingesetzt (1 Zoll = 2,54 cm). Somit müssen Wafer mit einem Durchmesser von ca. 200 mm transportiert und bearbeitet werden. Zur Fixierung und Handhabung dieser Wafer wurde in der Montagetechnik der Mikroelektronik bisher ein Metallwaferrahmen eingesetzt.

EP-A-0 671 763 beschreibt einen aus Kunststoff hergestellten Waferrahmen.

Der Erfindung liegt die Aufgabe zugrunde, bei gleichen Qualitätsanforderungen bezüglich der Feuchteaufnahme, der Biegefestigkeit und der Warmformbeständigkeit einen Waferrahmen zu liefern, der die Handhabung wesentlich vereinfacht. Die Lösung geschieht durch die Merkmale des Anspruchs 1.

Der Erfindung liegt die Erkenntnis zugrunde, daß ein geeigneter Kunststoff verbesserte Materialeigenschaften erreichen kann, wenn ein bestimmter Glasfaseranteil zugemischt ist. So kann dies beispielsweise das E-Modul, die Biegefestigkeit und die Warmformbeständigkeit positiv beeinflußen.

Die Anforderungen liegen beispielsweise wie folgt:

| | |
|---|---|
| Wärmeformbeständigkeit | ≥ 120 °C nach Martens, Vicat |
| Feuchteaufnahme | ≤ 0,8 % nach amerikanischer Nnorm bei 23° C |
| Biegefestigkeit | ≥ 120 Mpa (gemessen bei 23°C) |
| Biege-E-Modul | 10.000 - 18.000 N/***mm***^{**2**} (gemessen bei 23°C) |

Bei der Verwendung eines Kunststoff-Waferrahmens ergibt sich im Vergleich mit einem Metall-Waferrahmen eine Gewichtsersparnis von 48 bis 58 %. Dabei genügt der KunststoffWaferrahmen den technischen Anforderungen, da ein Glasfaseranteil untergemischt ist. Unter Glasfaseranteil ist eine pulverartige Substanz bestehend aus kleinen Glasfaserstücken bzw. -stäben gemeint.

Vorteilhafte Ausgestaltungen können den Unteransprüchen entnommen werden.

Im folgenden wird anhand von zwei schematischen Figuren ein Ausführungsbeispiel beschrieben.
Figur 1 zeigt einen Waferrahmen 2 in der Draufsicht, wobei die Verhältnisse zwischen Waferrahmen, Durchgang und Wafer angedeutet sind,
Figur 2 zeigt eine Kassette in einer geschnittenen Seitenansicht zur Aufnahme einer Vielzahl von Waferrahmen.

Erfindungsgemäß wird ein Waferrahmen aus Kunststoff vorgestellt, der Wafer mit einem Durchmesser von 200 mm aufnehmen kann. Die Fixierung und die Handhabung von Wafern mit einem derartigen Durchmesser (8 Zoll = 200 mm ) für die Bearbeitung in der Montagetechik der Mikroelektronik ist mit technischen Veränderungen verbunden, da die Waferrahmen bisher aus Metall gefertigt wurden. Für die Anpassung an größere Wafer unter Beibehaltung anderer bestehender Randbedingungen würde beispielsweise eine Kassette 3, die beispielsweise 25 Waferrahmen 2 mit jeweils darauf plazierter Folie 4 und Wafer 1 beinhaltet, ein wesentliches sehr unhandliches Gewicht erreichen, wenn die Waferrahmen aus Metall sind. Liegt das Gewicht eines Metallwaferrahmens dieser Größenordnung bei ca. 160g, so läßt sich durch Einsatz eines stabilen und warmfesten Kunststoffes eine Gewichtsersparnis von bis zu 58 % erzielen. Dabei kann der Kunststoffwaferrahmen auch den technischen Anforderungen bezüglich der mechanischen- und Temperaturbelastungs-Anforderungen entsprechen. Diese sind teilweise in der **D**eutschen **I**ndustrie **N**orm oder in den Normen für **A**merikanische **ST**andardisierung für **M**aschinenbau enthalten.

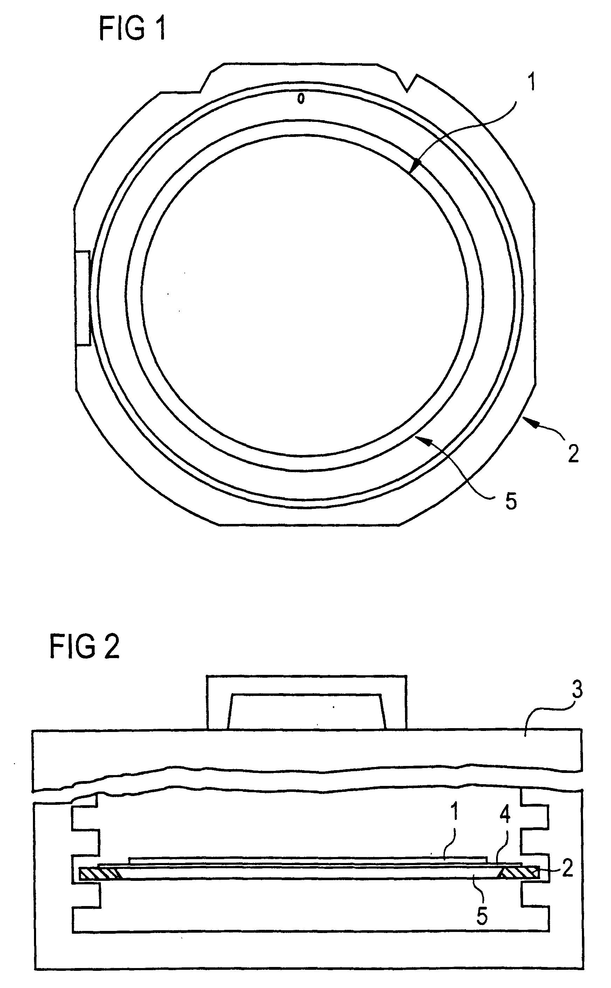

Die Figur 1 zeigt die Draufsicht auf einen Waferrahmen 2 mit dem zentralen kreisförmigen Durchgang 5. Weiterhin ist die Positionierung eines Wafers 1 angedeutet. Der äußere Durchmesser des Waferrahmens 2 beträgt beispielsweise 296 mm und der Durchmesser des Durchganges 5 beispielsweise 250 mm.

In der Figur 2 ist eine Kassette 3 angedeutet, die in einem inneren Stufenraster eine Mehrzahl von Waferrahmen 2 aufnehmen kann, die seitswärts eingeschoben werden. Mit dieser Kassette 3 werden die Wafer 1 zwischen verschiedenen Fertigungsstationen transportiert. An einer Fertigungsstation werden sie sukzessive den entsprechenden Bearbeitungsprozessen zugeführt. In Figur 2 ist auf dem Waferrahmen 2 eine selbstklebende Kunststoff-Folie 4 aufgebracht, auf der der Wafer 1 zentral plaziert ist. Der Durchmesser des Wafers 1 ist dabei kleiner als der Durchmesser des Durchganges 5. Somit ist gewährleistet, daß ein sog. Vakuumchuck zum Fixieren durch Ansaugen von unten durch den Waferrahmen 2 hindurchführbar ist und den Wafer 1 mittelbar über die Folie 4 aufnimmt.

Ein erfindungsgemäßer Kunststoff mit einem Glasfaseranteil von bis zu 40% erfüllt sämtliche Materialanforderungen für die Verwendung bei einem Waferrahmen 2. Die durchschnittlichen Glasfasergewichtsanteile liegen bei 20 bis 40 % für die Kunststoffe Polyphenylensulfon (PPS), Polyethersulfon (PES) und für Polyetheretherketon (PEEK). Die Zumischungen für Liquid Crystal Polymere (LCP) liegen in vorteilhafterweise zwischen 1 und 20 %. Diese Werkstoffe sind unter verschiedenen Handelsnamen bekannt und werden beispielsweise in Deutschland von den Firmen BASF-Ludwigshafen, Bayer-Leverkusen und Du-Pont-Bad Homburg vertrieben.

### Bezugszeichenliste

- 1: Wafer
- 2: Waferrahmen
- 3: Kassette
- 4: Folie
- 5: Durchgang

## Patentansprüche

1. Waferrahmen zur Aufnahme und zum Transport von Halbleiter-Wafern (1) in der Montagetechnik der Mikroelektronik bestehend aus einem plattenförmigen Grundkörper mit einem zentralen kreisförmigen Durchgang (5) zur Aufnahme einer Folie (4) und einem auf der Folie plazierten Wafer (1),
**dadurch gekennzeichnet, daß** der Waferrahmen (2) aus einem Kunststoff mit einem Glasfaseranteil von 1 bis 40 Gewicht-% besteht.

2. Waferrahmen nach Anspruch 1, worin der Kunststoff ein Polyphenylensulfon (PPS) ist.

3. Waferrahmen nach Anspruch 1, worin der Kunststoff ein Polyethersulfon (PES) ist.

4. Waferrahmen nach Anspruch 1, worin der Kunststoff ein Polyetheretherketon (PEEK) ist.

5. Waferrahmen nach einem der Ansprüche 2 bis 4, worin der Glasfaseranteil in einem Bereich von 20 bis 40 Gewicht-% liegt.

6. Waferrahmen nach Anspruch 1, worin der Kunststoff ein Liquid Crystal Polymer (LCP) ist.

7. Waferrahmen nach Anspruch 6, worin der Glasfaseranteil im Bereich von 1 bis 20 Gewicht-% liegt.

## Claims

1. Wafer frame for accommodating and conveying semiconductor wafers (1) in microelectronics mounting technology, comprising a plate-like base body with a central circular passage (5) for accommodating a film (4) and a wafer (1) which has been placed on the film,
**characterized in that** the wafer frame (2) consists of a plastic with a glass fibre content of from 1 to 40% by weight.

2. Wafer frame according to Claim 1, wherein the plastic is a polyphenylene sulphone (PPS).

3. Wafer frame according to Claim 1, wherein the plastic is a polyether sulphone (PES).

4. Wafer frame according to Claim 1, wherein the plastic is a polyether ether ketone (PEEK).

5. Wafer frame according to one of Claims 2 to 4, wherein the glass fibre content lies in a range from 20 to 40% by weight.

6. Wafer frame according to Claim 1, wherein the plastic is a liquid crystal polymer (LCP).

7. Wafer frame according to Claim 6, wherein the glass fibre content lies in the range from 1 to 20% by weight.

## Revendications

1. Cadre de galettes destiné à recevoir et à transporter des galettes (1) de semi-conducteur dans la technique de montage de la micro-électronique, constitué d'une embase en forme de plaque ayant un passage (5) central circulaire de réception d'une feuille (4) et une galette (1) placée sur la feuille,
**caractérisé en ce que** le cadre (2) de galettes est en une matière plastique ayant une proportion de fibres de verre de 1 à 40 % en poids.

2. Cadre de galettes suivant la revendication 1, dans lequel la matière plastique est une polyphénylènesulfone (PPS).

3. Cadre de galettes suivant la revendication 1, dans lequel la matière plastique est une polyéthersulfone (PES).

4. Cadre de galette suivant la revendication 1, dans lequel la matière plastique est une polyétheréthercétone (PEEK).

5. Cadre de galettes suivant l'une des revendications 2 à 4, dans lequel la proportion de fibres de verre est comprise entre 20 et 40 % en poids.

6. Cadre de galettes suivant la revendication 1, dans lequel la matière plastique est un polymère de cristal liquide (LCP).

7. Cadre de galettes suivant la revendication 6, dans lequel la proportion de fibres de verre est de l'ordre de 1 à 20 % en poids.
